# EUROPEAN PATENT APPLICATION

(11) **EP 4 726 407 A1**
(43) Date of publication of application: **15.04.2026**
(21) Application number: 25749118.3
(22) Date of filing: 21.01.2025
(51) Int. Cl.: G01R 31/367, G01R 31/382, G01R 31/396, H02J 7/00, G06V 10/82, G06N 3/08

(54) **APPARATUS AND METHOD FOR DIAGNOSING BATTERY**

(30) Priority: 30.01.2024 KR 20240014383
(71) Applicant: LG Energy Solution, Ltd., Seoul 07335 (KR)
(72) Inventor: PAK, Seon-Ho, Daejeon 34122 (KR); JEONG, Hee-Seok, Daejeon 34122 (KR); BAE, Yoon-Jung, Daejeon 34122 (KR)
(74) Representative: Goddar, Heinz J.
(86) International application number: PCT/KR2025/001150
(87) International publication number: WO 2025/165031

(57) **Abstract**

The apparatus for diagnosing a battery according to an embodiment of the present disclosure includes a profile obtaining unit configured to obtain one or more profiles based on voltage and capacity of a battery; an image converting unit configured to convert each of the one or more profiles into an image and generate a diagnostic image from the converted one or more images; and a control unit configured to diagnose a state of the battery corresponding to the diagnostic image using a pre-learned diagnostic model.

## Description

### TECHNICAL FIELD

This application is based on and claims priority from Korean Patent Application No. 10-2024-0014383, filed on January 30, 2024, with the Korean Intellectual Property Office, the disclosure of which is incorporated herein in its entirety by reference.

The present disclosure relates to an apparatus and method for diagnosing a battery, and more particularly, to an apparatus and method for diagnosing a battery, which diagnoses a state of a battery.

### BACKGROUND ART

Recently, the demand for portable electronic products such as notebook computers, video cameras and portable telephones has increased sharply, and electric vehicles, energy storage batteries, robots, satellites and the like have been developed in earnest. Accordingly, high-performance batteries allowing repeated charging and discharging are being actively studied.

Batteries commercially available at present include nickel-cadmium batteries, nickel hydrogen batteries, nickel-zinc batteries, lithium batteries and the like. Among them, the lithium batteries are in the limelight since they have almost no memory effect compared to nickel-based batteries and also have very low self-charging rate and high energy density.

Although much research is being conducted on these batteries in terms of high capacity and high density, improving lifespan and safety is also important. In order to improve battery safety, technology that accurately diagnoses the current state of the battery is required.

In particular, if a problem occurs with a battery in operation, it may result in loss of life and financial damage. Therefore, a technology is required to predict the state of the battery in advance and prevent unexpected accidents from occurring.

### DISCLOSURE

### Technical Problem

The present disclosure is designed to solve the problems of the related art, and therefore the present disclosure is directed to providing an apparatus and method for diagnosing a battery, which diagnoses a state of a battery.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

### Technical Solution

An apparatus for diagnosing a battery according to one aspect of the present disclosure may comprise a profile obtaining unit configured to obtain one or more profiles based on voltage and capacity of a battery; an image converting unit configured to convert each of the one or more profiles into an image and generate a diagnostic image from the converted one or more images; and a control unit configured to diagnose a state of the battery corresponding to the diagnostic image using a pre-learned diagnostic model.

The diagnostic model may be trained to determine the state of the battery from the diagnostic image through preset learning data.

The control unit may be configured to diagnose the state of the battery corresponding to a target cycle from the diagnostic image using the diagnostic model.

The image converting unit may be configured to convert a profile for a cycle lower than or equal to a reference cycle preset to correspond to the target cycle among the one or more profiles to an image.

The reference cycle may be preset as a cycle in which accuracy of a verification result for the target cycle is greater than or equal to a preset reference value, in a verification process of the diagnostic model for preset verification data.

The reference cycle may preset as a lowest cycle among a plurality of cycles in which the accuracy of the verification result is greater than or equal to the reference value.

The diagnostic model may be configured to generate a diagnostic result image that displays a key area considered in determining the state of the battery in an entire area of the diagnostic image.

The diagnostic model may be configured to further display importance for the key area in the diagnostic result image.

The diagnostic model may be configured to display an area in which the importance is greater than or equal to a preset threshold value as the key area in the entire area of the diagnostic image.

The control unit may be configured to diagnose a cause of the state of the battery as one of a preset plurality of reference causes and set a usage condition of the battery to correspond to the diagnostic result.

The image converting unit may be configured to generate the diagnostic image by synthesizing the one or more images.

A battery pack according to another aspect of the present disclosure may comprise the apparatus for diagnosing a battery according to one aspect of the present disclosure.

A server according to still another aspect of the present disclosure may comprise the apparatus for diagnosing a battery according to one aspect of the present disclosure.

A method for diagnosing a battery according to still another aspect of the present disclosure may comprise a profile obtaining step of obtaining one or more profiles based on voltage and capacity of a battery; an image converting step of converting each of the one or more profiles into an image and generate a diagnostic image from the converted one or more images; and a diagnosing step of diagnosing a state of the battery corresponding to the diagnostic image using a pre-learned diagnostic model.

### Advantageous Effects

According to one aspect of the present disclosure, the apparatus for diagnosing a battery diagnoses the state of the battery through an image, and thus has the advantage of being able to quickly diagnose the state of the battery using an image of the battery profile.

In addition, according to one aspect of the present disclosure, the apparatus for diagnosing a battery may not only track and diagnose the state of the battery from the past to the present, but also predict the future state of the battery. Since the state of the entire cycle of the battery may be tracked, the apparatus for diagnosing a battery may detect in advance whether a problem occurs in the battery.

The effects of the present disclosure are not limited to the effects mentioned above, and other effects not mentioned will be clearly understood by those skilled in the art from the description of the claims.

### DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.
FIG. 1 is a diagram schematically showing an apparatus for diagnosing a battery according to an embodiment of the present disclosure.
FIG. 2 is a drawing schematically showing a plurality of profiles according to an embodiment of the present disclosure.
FIG. 3 is a drawing schematically showing a verification result of a diagnostic model according to an embodiment of the present disclosure.
FIG. 4 to FIG. 7 are drawings schematically showing a diagnostic result image according to an embodiment of the present disclosure.
FIG. 8 is a drawing schematically showing a battery pack according to another embodiment of the present disclosure.
FIG. 9 is a drawing schematically showing a server according to still another embodiment of the present disclosure.
FIG. 10 is a diagram schematically showing a method for diagnosing a battery according to still another embodiment of the present disclosure.

### BEST MODE

It should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other equivalents and modifications could be made thereto without departing from the scope of the disclosure.

Additionally, in describing the present disclosure, when it is deemed that a detailed description of relevant known elements or functions renders the key subject matter of the present disclosure ambiguous, the detailed description is omitted herein.

The terms including the ordinal number such as "first", "second" and the like, may be used to distinguish one element from another among various elements, but not intended to limit the elements by the terms.

Throughout the specification, when a portion is referred to as "comprising" or "including" any element, it means that the portion may include other elements further, without excluding other elements, unless specifically stated otherwise.

In addition, throughout the specification, when a portion is referred to as being "connected" to another portion, it is not limited to the case that they are "directly connected", but it also includes the case where they are "indirectly connected" with another element being interposed between them.

Hereinafter, a preferred embodiment of the present disclosure will be described in detail with reference to the accompanying drawings.

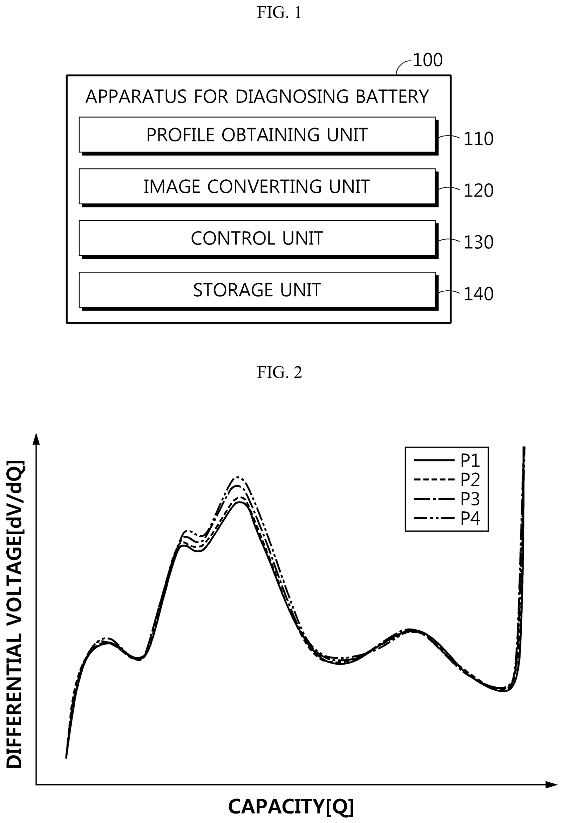

FIG. 1 is a diagram schematically illustrating an apparatus 100 for diagnosing a battery according to an embodiment of the present disclosure.

Referring to FIG. 1, the apparatus 100 for diagnosing a battery may include a profile obtaining unit 110, an image converting unit 120, and a control unit 130.

Here, the battery refers to an independent cell that has a negative terminal and a positive terminal and is physically separable. As an example, a lithium-ion battery or a lithium polymer battery may be considered as a battery. In addition, the type of batteries may be a cylindrical type, a prismatic type or a pouch type. Additionally, the battery may mean a battery bank, a battery module or a battery pack in which a plurality of cells are connected in series and/or parallel. Below, for convenience of explanation, the battery is explained as meaning one independent cell.

The profile obtaining unit 110 may be configured to obtain one or more profiles based on voltage and capacity of the battery.

Specifically, a profile may be obtained without limitation on the type if it is a profile related to the voltage and capacity of the battery. For example, a profile, such as a battery profile and a differential profile, may be obtained based on the voltage and capacity of the battery.

For example, the battery profile is a profile representing the corresponding relationship between voltage V and capacity Q when the SOC of the battery is charged from a preset charge start SOC, or 0%, to a preset charge end SOC, or 100%. As another example, the battery profile may represent the corresponding relationship between voltage V and capacity Q when the state of charge of the battery is discharged from the preset discharge start SOC, or 100%, to the preset discharge end SOC, or 0%.

The differential profile may include a differential capacity profile and a differential voltage profile. The differential capacity profile is a profile obtained by differentiating the battery profile with respect to voltage, and is a profile that represents the corresponding relationship between the differential capacity (dQ/dV) and voltage (V). The differential voltage profile is a profile obtained by differentiating the battery profile with respect to capacity, and is a profile that represents the corresponding relationship between the differential voltage (dV/dQ) and capacity (Q).

For example, there is no special limitation on the C-rate in charging or discharging for generating the battery profile. However, preferably, the battery should be charged or discharged at a low rate in order to obtain a more accurate battery profile and differential profile. For example, the battery profile may be generated in the process of charging or discharging the battery at 0.05 C.

For example, the profile obtaining unit 110 may directly receive the profile for the battery from the outside. That is, the profile obtaining unit 110 may obtain the profile for the battery by being connected to the outside via wire and/or wirelessly and receiving the profile.

As another example, the profile obtaining unit 110 may receive the battery information about the voltage and capacity of the battery. Then, the profile obtaining unit 110 may generate a profile for the battery based on the received battery information. That is, the profile obtaining unit 110 may obtain the profile for the battery by directly generating the profile based on the battery information.

FIG. 2 is a drawing schematically showing a plurality of profiles according to an embodiment of the present disclosure. Here, the profile is a differential voltage profile that represents the corresponding relationship between the capacity and the differential voltage. And, the profile may be expressed as an X-Y graph where the X-axis is set to the capacity (Q) and the Y-axis is set to the differential voltage (dV/dQ).

In the embodiment of FIG. 2, the profile obtaining unit 110 may obtain a first profile P1, a second profile P2, a third profile P3, and a fourth profile P4.

The profile obtaining unit 110 may be communicatively connected to the image converting unit 120. For example, the profile obtaining unit 110 may be connected to the image converting unit 120 by wire and/or wirelessly. The profile obtaining unit may transmit the obtained one or more profiles to the image converting unit 120.

The image converting unit 120 may be configured to convert each of the one or more profiles into an image and generate a diagnostic image from the converted one or more images.

Specifically, the image converting unit 120 may convert a profile into an image. For example, in the embodiment of FIG. 2, each of the first profile P1, the second profile P2, the third profile P3, and the fourth profile P4 may be converted into an image. That is, the image converting unit 120 may generate a total of four images.

In the embodiment of FIG. 2, the profile is expressed as an X-Y graph, but the profile may also be in the form of a table listing battery information for the measurement time point. In this case, the image converting unit 120 may convert the profile into an X-Y graph, and then convert the profile expressed as an X-Y graph into an image.

Additionally, the image converting unit 120 may be configured to generate a diagnostic image by synthesizing one or more images.

Preferably, the one or more profiles obtained by the profile obtaining unit 110 may have the same axis scale. Specifically, an axis scale corresponding to each of the battery profile, the differential voltage profile, or the differential capacity profile may be preset.

Since the one or more images generated by the image converting unit 120 have the same axis scale, the image converting unit 120 may generate a diagnostic image by synthesizing the generated one or more images. Specifically, the image converting unit 120 may generate a diagnostic image by overlapping the generated one or more images.

The control unit 130 may be configured to diagnose the state of the battery corresponding to the diagnostic image using a pre-learned diagnostic model.

The diagnostic model may be trained to determine the state of the battery from a diagnostic image through preset learning data. Here, the diagnostic model may be applied without limitation as long as it is a model that can learn and analyze an input diagnostic image based on the learning result. For example, the diagnostic model may be set as an artificial neural network (ANN) based on deep learning. As a specific example, the diagnostic model may include a convolutional neural network (CNN), a recurrent neural network (RNN), a transformer, or a mixed model based on them.

And, the learning data is preset as a profile for a plurality of reference batteries, and the states of the plurality of reference batteries may be diverse. Preferably, the learning data may also be an image of the profile. For example, profiles for reference batteries in various states, such as sudden drop occurrence, lithium plating occurrence, positive electrode capacity loss, negative electrode capacity loss, internal gas generation, venting, fire occurrence, internal short circuit occurrence, and electrode lead (or electrode tab) disconnection, may be preset as learning data. Therefore, the diagnostic model may analyze the diagnostic image and output the state with the highest probability among the learned states as the state of the battery.

The control unit 130 may input the diagnostic image generated by the image converting unit 120 into the diagnostic model. Then, the control unit 130 may obtain the result output from the diagnostic model and diagnose the state of the battery based on the obtained result.

Preferably, the learning data may be preset as an image of a profile for life cycle of each of the plurality of reference batteries. For example, for each of the plurality of reference batteries, at least one among an image for each cycle, a composite image for some cycles, and a composite image for the entire cycle may be set as learning data. Accordingly, the control unit 130 may diagnose the past state, the current state, and/or the future state of the battery using the diagnostic model. For example, the control unit 130 may diagnose what state the battery was in in the past, what state the battery is in currently, and what state the battery will be in in the future.

For example, in the embodiment of FIG. 2, the control unit 130 may input a diagnostic image based on a plurality of profiles P1, P2, P3, P4 into the diagnostic model. The control unit 130 may diagnose the past state and the current state of the battery as a normal state based on the results output from the diagnostic model. However, the control unit 130 may diagnose the future state of the battery as a sudden drop occurrence state.

The apparatus 100 for diagnosing a battery according to an embodiment of the present disclosure diagnoses the state of the battery through an image, and therefore has the advantage of being able to quickly diagnose the state of the battery using an image of the battery profile.

In addition, the apparatus 100 for diagnosing a battery may not only track and diagnose the state of the battery from the past to the present, but also predict the future state of the battery. Since the state of the entire cycle of the battery may be tracked, the apparatus 100 for diagnosing a battery may detect in advance whether a problem occurs in the battery. Accordingly, the expected life of the battery may be dramatically increased by appropriately setting the usage conditions for the battery based on the diagnostic result by the apparatus 100 for diagnosing a battery.

Meanwhile, the profile obtaining unit 110, the image converting unit 120 and the control unit 130 included in the apparatus 100 for diagnosing a battery may optionally include processors, application-specific integrated circuits (ASICs), other chipsets, logic circuits, registers, communication modems, data processing devices, etc. known in the art to execute various control logics performed in the present disclosure. Also, when the control logic is implemented as software, the profile obtaining unit 110, the image converting unit 120 and the control unit 130 may be implemented as a set of program modules.

In addition, the apparatus 100 for diagnosing a battery may further include a storage unit 140. The storage unit 140 may store data necessary for operation and function of each component of the apparatus 100 for diagnosing a battery, data generated in the process of performing the operation or function, or the like. The storage unit 140 is not particularly limited in its kind as long as it is a known information storage means that can record, erase, update and read data. As an example, the information storage means may include RAM (Random access memory), flash memory, ROM (Read-only memory), EEPROM (Electrically erasable programmable read-only memory), registers, and the like. In addition, the storage unit 140 may store program codes in which processes executable by the profile obtaining unit 110, the image converting unit 120 and the control unit 130 are defined.

For example, the storage unit 140 may store the one or more profiles, the diagnostic image, the diagnostic model, etc. obtained by the profile obtaining unit 110.

The image converting unit 120 may be configured to convert a profile for a cycle lower than or equal to a reference cycle preset to correspond to a target cycle among the one or more profiles into an image.

Specifically, the image converting unit 120 may convert only a number of profiles corresponding to the target cycle into images, rather than converting all profiles obtained by the profile obtaining unit 110 into images. Here, since a reference cycle corresponding to the target cycle is set in advance, the image converting unit 120 may convert only profiles for cycles less than or equal to the reference cycle into images.

For example, it is assumed that the profile obtaining unit 110 obtains profiles for the first cycle to the 100th cycle, the target cycle is the 200th cycle, and the reference cycle corresponding to the target cycle is the 50th cycle. The image converting unit 120 may not convert all 100 profiles (the first to the 100th cycle) into images, but may convert 50 profiles (the first to the 50th cycle) into images. In other words, the remaining 50 profiles (the 51st to 100th cycle) may not be converted into images.

The reference cycle may be preset as a cycle in which the accuracy of the verification result for the target cycle is higher than or equal to the preset reference value during the verification process of the diagnostic model for preset verification data. Preferably, lastly, the cycle with the lowest accuracy of the verification result among a plurality of cycles that are higher than or equal to the reference value may be preset as the reference cycle.

Specifically, the verification process for a plurality of verification batteries was performed while increasing the number of cycles used for verifying the diagnostic model by n (where n is a natural number). Note that the verification battery is different from the reference battery, and information about the verification battery is not included in the learning data of the diagnostic model.

In each verification process, a verification image is generated by synthesizing the image of the profile of each of the plurality of verification batteries, and the generated verification image is input to the diagnostic model. Here, the synthesized profile is a profile for the cycle corresponding to each verification process. Then, the verification process is performed by calculating the accuracy by comparing the actual state of the verification battery in the target cycle with the diagnostic result of the diagnostic model.

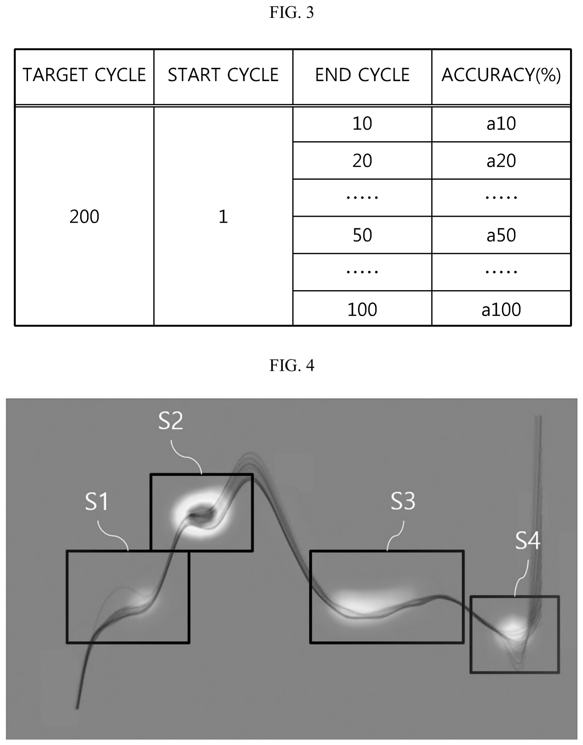

FIG. 3 is a drawing schematically showing a verification result of a diagnostic model according to an embodiment of the present disclosure. Specifically, the embodiment of FIG. 3 is a verification result of a diagnostic model for a target cycle (the 200th cycle) of a plurality of verification batteries. And, the verification process was performed a total of 10 times by increasing the cycle by 10 each time.

In the embodiment of FIG. 3, the accuracy corresponding to the first to tenth cycles is a10 (%). That is, the diagnostic accuracy of the diagnostic model for the verification image of each of the plurality of verification batteries is a10 (%). Here, the verification image is an image synthesized from the images of the profiles corresponding to the first to tenth cycles, for each of the plurality of verification batteries.

Next, the accuracy corresponding to the first to 20th cycles is a20 (%), the accuracy corresponding to the first to 50th cycles is a50 (%), and the accuracy corresponding to the first to 100th cycles is a100 (%).

Specifically, in the 10 verification processes, the cycles whose accuracy is higher than or equal to the reference accuracy are the 50th to 100th cycles. That is, the verification accuracy of the first to 50th cycles, the first to 60th cycles, the first to 70th cycles, the first to 80th cycles, the first to 90th cycles, and the first to 100th cycles is higher than or equal to the reference value.

Finally, since the lowest cycle having the accuracy higher than or equal to the reference value is the 50th cycle, the 50th cycle may be set as the reference cycle for the target cycle (the 200th cycle).

And, when the target cycle is set to the 200th cycle during the diagnostic process, the image converting unit 120 may convert the profile corresponding to the first to 50th cycles into an image and generate a diagnostic image using the converted images.

The control unit 130 may be configured to diagnose the state of the battery corresponding to the target cycle from a diagnostic image using a diagnostic model.

Specifically, the control unit 130 may diagnose the state of the battery in the target cycle using the diagnostic image. If the target cycle is a future cycle of the battery, the state of the battery in the target cycle may be predicted and diagnosed.

The diagnostic model may be configured to generate a diagnostic result image that displays a key area considered in determining the state of the battery in the entire area of the diagnostic image.

Here, the key area is an area where the diagnostic model intensively analyzes the diagnostic image to determine the state of the battery, and may be one or more areas. This key area may be determined based on the learning results for the reference battery.

For example, if there is a specific pattern in the profile of a reference battery in which a sudden drop occurs, this specific pattern may be learned. Then, the diagnostic model may consider an area where the specific pattern can appear as a key area to check whether the diagnostic image includes the specific pattern.

FIG. 4 to FIG. 7 are drawings schematically showing a diagnostic result image according to an embodiment of the present disclosure.

In the embodiments of FIGS. 4 to 7, a first area S1, a second area S2, a third area S3, and a fourth area S4 may be displayed in the diagnostic result image. In this embodiment, four areas are described as being displayed in the diagnostic result image, but the areas may be further subdivided depending on the learning data and learning design.

The diagnostic model may be configured to further display importance for the key area in the diagnostic result image.

Specifically, the diagnostic model may determine importance per key area and display the determined importance on the diagnostic result image. For example, the importance may be displayed as a number, symbol, heat map, etc.

For example, the diagnostic model may be a CNN with Grad-CAM (gradient-weighted class activation mapping) or Grad-CAM++ applied. Here, Grad-CAM may display which part of the diagnostic image influences the final classification determination (battery state determination) of the CNN.

Preferably, the entire area of the diagnostic image may be considered for diagnosing the state of the battery. However, the diagnostic model may be configured to display an area whose importance is greater than or equal to a preset threshold value in the entire area of the diagnostic image as a key area. That is, the key area considered most important for diagnosing the state of the battery and the importance of the area may be displayed in the diagnostic result image. Therefore, the user may very easily check the specific characteristics of the battery through the diagnostic result image.

For example, in the embodiments of FIGS. 4 to 7, the importance for each of the plurality of key areas S1, S2, S3, S4 may be displayed. In this embodiment, the importance is displayed in a heat map format, but any means capable of displaying importance may be applied without limitation.

The control unit 130 may be configured to diagnose the cause of the battery state as one of a preset plurality of reference causes.

Specifically, the control unit 130 may diagnose the state of the battery for the target cycle using the diagnostic model. In addition, the control unit 130 may further diagnose the cause of the state of the battery based on the diagnostic result image. That is, since the key area is displayed in the diagnostic result image, the control unit 130 may diagnose the cause of the state of the battery from the diagnostic result image.

For example, the plurality of reference causes may include predominant negative electrode degradation, predominant positive electrode degradation, and balanced degradation. Here, predominant negative electrode degradation means that the negative electrode is more degraded than the positive electrode, and the degradation balance between the positive electrode and the negative electrode is broken. Conversely, predominant positive electrode degradation means that the positive electrode is more degraded than the negative electrode, and the degradation balance between the positive electrode and the negative electrode is broken. In addition, balanced degradation means that the positive electrode and the negative electrode are degraded in a balanced manner.

Additionally, the control unit 130 may be configured to set the usage conditions of the battery corresponding to the diagnostic result.

For example, if the cause of the battery state is diagnosed as a negative electrode degradation state, the control unit 130 may reduce the upper charge limit C-rate to prevent the negative electrode from being degraded more than the positive electrode. In the embodiment of FIG. 4, the control unit 130 may diagnose the cause of sudden death as a negative electrode degradation state and reduce the upper charge limit C-rate set for the battery.

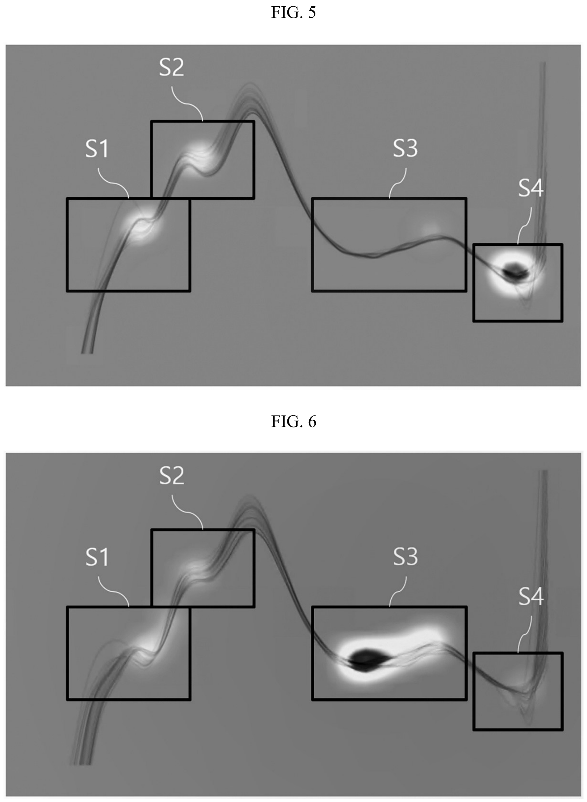

As another example, if the cause of the battery state is diagnosed as a positive electrode degradation state, the control unit 130 may reduce the charge upper limit voltage to prevent the positive electrode from being degraded more than the negative electrode. In the embodiments of FIGS. 5 and 6, the control unit 130 may diagnose the cause of sudden death as a positive electrode degradation state and reduce the charge upper limit voltage set for the battery. In addition, in the embodiment of FIG. 6, since the importance of the third key area S3 is high, the charge upper limit C-rate may be reduced in the capacity section corresponding to the third key area S3 to prevent further degradation in the third key area S3.

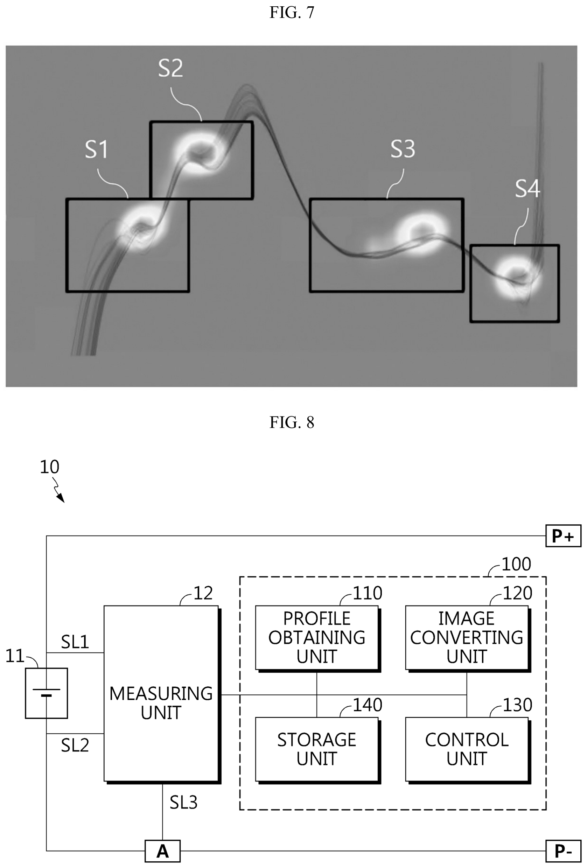

As still another example, if the cause of the battery state is diagnosed as a balanced degradation state, the charge upper limit C-rate and the charge upper limit voltage may be reduced. In the embodiment of FIG. 7, the control unit 130 may diagnose the cause of sudden death as a balanced degradation state and reduce the charge upper limit C-rate and the charge upper limit voltage set for the battery.

The apparatus 100 for diagnosing a battery may diagnose the state of the battery and the cause of the state, and set the usage conditions of the battery to correspond to the diagnostic result. That is, according to the apparatus 100 for diagnosing a battery, the expected life of the battery may be increased, and unexpected accidents may be prevented in advance.

The apparatus 100 for diagnosing a battery according to the present disclosure may be applied to a battery management system (BMS). That is, the BMS according to the present disclosure may include the apparatus 100 for diagnosing a battery described above. In this configuration, at least some of components of the apparatus 100 for diagnosing a battery may be implemented by supplementing or adding functions of the components included in a conventional BMS. For example, the profile obtaining unit 110, the image converting unit 120, the control unit 130 and the storage unit 140 of the apparatus 100 for diagnosing a battery may be implemented as components of the BMS.

Additionally, the apparatus 100 for diagnosing a battery according to the present disclosure may be provided in the battery pack. That is, the battery pack according to the present disclosure may include the above-described apparatus 100 for diagnosing a battery and at least one battery cell. Additionally, the battery pack may further include electrical components (relays, fuses, etc.) and a case.

FIG. 8 is a drawing schematically showing a battery pack 10 according to another embodiment of the present disclosure.

The positive electrode terminal of the battery 11 may be connected to the positive electrode terminal P+ of the battery pack 10, and the negative electrode terminal of the battery 11 may be connected to the negative electrode terminal P- of the battery pack 10.

The measuring unit 12 may be connected to the first sensing line SL1, the second sensing line SL2, and the third sensing line SL3. Specifically, the measuring unit 12 may be connected to the positive electrode terminal of the battery 11 through the first sensing line SL1 and connected to the negative electrode terminal of the battery 11 through the second sensing line SL2. The measuring unit 12 may measure the voltage of the battery 11 based on the voltage measured at each of the first sensing line SL1 and the second sensing line SL2.

Also, the measuring unit 12 may be connected to the current measuring unit A through the third sensing line SL3. For example, the current measuring unit A may be an ammeter or a shunt resistor capable of measuring the charging current and the discharging current of the battery 11. The measuring unit 12 may measure the charging current of the battery 11 through the third sensing line SL3 to calculate the charge amount. In addition, the measuring unit 12 may measure the discharging current of the battery 11 through the third sensing line SL3 to calculate the discharge amount.

For example, the profile obtaining unit 110 may receive battery information about the voltage and current of the battery from the measuring unit 12. Then, the profile obtaining unit 110 may generate a profile based on the battery information.

As another example, the profile obtaining unit 110 may receive a profile from the measuring unit 12.

An external device may be connected to the positive electrode terminal P+ and the negative electrode terminal P- of the battery pack 10. For example, the external device may be a charging device or a load. In addition, the positive electrode terminal of the battery 11, the positive electrode terminal P+ of the battery pack 10, the external device, the negative electrode terminal P- of the battery pack 10, and the negative electrode terminal of the battery 11 may be electrically connected.

For example, the battery pack 10 may be included in a vehicle, such as an electric vehicle (EV) or a hybrid vehicle (HV). In addition, the battery pack 10 may drive the vehicle by supplying power to a motor through an inverter provided in the vehicle.

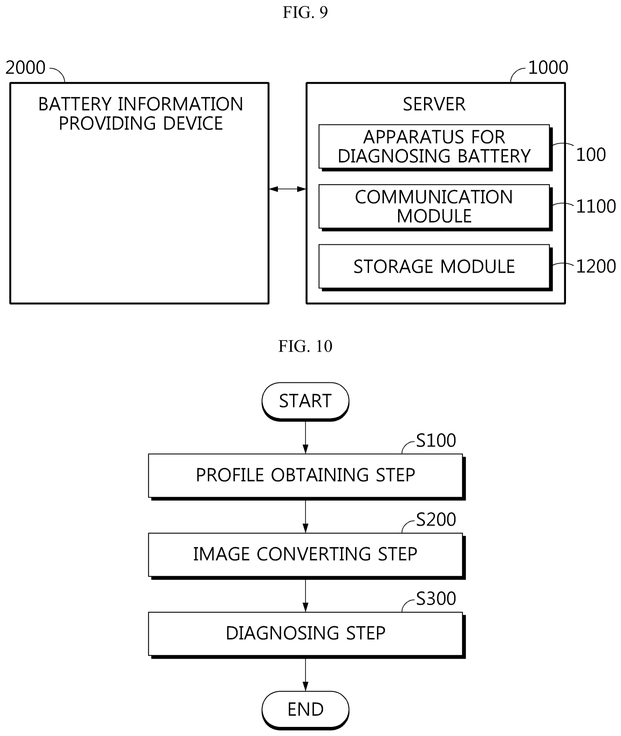

FIG. 9 is a drawing schematically showing a server 1000 according to still another embodiment of the present disclosure.

Referring to FIG. 9, the server 1000 may include the apparatus 100 for diagnosing a battery, a communication module 1100, and a storage module 1200. In addition, the server 1000 may be configured to communicate with a battery information providing device 2000. For example, the battery information providing device 2000 may be a device capable of providing battery information and/or profile to the server 1000, and may be a BMS, a charging device, a diagnostic device, or the like.

The communication module 1100 may be connected to communicate with the battery information providing device 2000 via wired and/or wireless means. For example, the communication module 1100 may receive battery information and/or profile from the battery information providing device 2000.

The apparatus 100 for diagnosing a battery may be connected to communicate with the communication module 1100 via a wire and/or wireless connection. The apparatus 100 for diagnosing a battery may diagnose the state of the battery by obtaining battery information and/or profile received by the communication module 1100.

The storage module 1200 may store battery information and/or profile received by the communication module 1100. In addition, the storage module 1200 may store diagnostic images, diagnostic result images, and diagnostic models used for diagnosing the state of the battery.

Preferably, the server 1000 is connected to communicate with a plurality of battery information providing devices, and may diagnose the state of a corresponding battery based on data received from each of the plurality of battery information providing devices.

FIG. 10 is a diagram schematically showing a method for diagnosing a battery according to still another embodiment of the present disclosure.

Referring to FIG. 10, the method for diagnosing a battery may include a profile obtaining step (S100), an image converting step (S200), and a diagnosing step (S300).

Preferably, each step of the method for diagnosing a battery may be performed by the apparatus 100 for diagnosing a battery. Hereinafter, for convenience of explanation, content that overlaps with the content described above will be omitted or briefly described.

The profile obtaining step (S100) is a step of obtaining one or more profiles based on voltage and capacity of a battery, and may be performed by the profile obtaining unit 110.

For example, the profile obtaining unit 110 may directly receive a profile for the battery from the outside. That is, the profile obtaining unit 110 may obtain the profile for the battery by being connected to the outside via wire and/or wirelessly and receiving the profile.

As another example, the profile obtaining unit 110 may receive battery information about the voltage and capacity of the battery. Then, the profile obtaining unit 110 may generate a profile for the battery based on the received battery information. That is, the profile obtaining unit 110 may obtain the profile for the battery by directly generating the profile based on the battery information.

The image converting step (S200) is a step of converting each of one or more profiles into an image and generating a diagnostic image from the converted one or more images, and may be performed by the image converting unit 120.

Specifically, the image converting unit 120 may convert a profile into an image. In addition, the image converting unit 120 may be configured to generate a diagnostic image by synthesizing one or more images.

The diagnosing step (S300) is a step of diagnosing the state of a battery corresponding to the diagnostic image using a pre-learned diagnostic model, and may be performed by the control unit 130.

The control unit 130 may input the diagnostic image generated by the image converting unit 120 into the diagnostic model. Then, the control unit 130 may obtain the result output from the diagnostic model and diagnose the state of the battery based on the obtained result.

Furthermore, the control unit 130 may further diagnose the cause of the battery state based on the diagnostic result image. That is, since the key area is displayed in the diagnostic result image, the control unit 130 may diagnose the cause of the battery state from the diagnostic result image.

The embodiments of the present disclosure described above may not be implemented only through an apparatus and a method, but may be implemented through a program that realizes a function corresponding to the configuration of the embodiments of the present disclosure or a recording medium on which the program is recorded. The program or recording medium may be easily implemented by those skilled in the art from the above description of the embodiments.

The present disclosure has been described in detail. However, it should be understood that the detailed description and specific examples, while indicating preferred embodiments of the disclosure, are given by way of illustration only, since various changes and modifications within the scope of the disclosure will become apparent to those skilled in the art from this detailed description.

Additionally, many substitutions, modifications and changes may be made to the present disclosure described hereinabove by those skilled in the art without departing from the technical aspects of the present disclosure, and the present disclosure is not limited to the above-described embodiments and the accompanying drawings, and each embodiment may be selectively combined in part or in whole to allow various modifications.

### (Explanation of reference signs)

10: battery pack
11: battery
12: measuring unit
100: apparatus for diagnosing a battery
110: profile obtaining unit
120: image converting unit
130: control unit
130: storage unit
1000: server
1100: communication module
1200: storage module
2000: battery information providing device

## Claims

1. An apparatus for diagnosing a battery, comprising:
a profile obtaining unit configured to obtain one or more profiles based on voltage and capacity of a battery;
an image converting unit configured to convert each of the one or more profiles into an image and generate a diagnostic image from the converted one or more images; and
a control unit configured to diagnose a state of the battery corresponding to the diagnostic image using a pre-learned diagnostic model.

2. The apparatus for diagnosing a battery according to claim 1,
wherein the diagnostic model is trained to determine the state of the battery from the diagnostic image through preset learning data.

3. The apparatus for diagnosing a battery according to claim 1,
wherein the control unit is configured to diagnose the state of the battery corresponding to a target cycle from the diagnostic image using the diagnostic model.

4. The apparatus for diagnosing a battery according to claim 3,
wherein the image converting unit is configured to convert a profile for a cycle lower than or equal to a reference cycle preset to correspond to the target cycle among the one or more profiles to an image.

5. The apparatus for diagnosing a battery according to claim 4,
wherein the reference cycle is preset as a cycle in which accuracy of a verification result for the target cycle is greater than or equal to a preset reference value, in a verification process of the diagnostic model for preset verification data.

6. The apparatus for diagnosing a battery according to claim 5,
wherein the reference cycle is preset as a lowest cycle among a plurality of cycles in which the accuracy of the verification result is greater than or equal to the reference value.

7. The apparatus for diagnosing a battery according to claim 1,
wherein the diagnostic model is configured to generate a diagnostic result image that displays a key area considered in determining the state of the battery in an entire area of the diagnostic image.

8. The apparatus for diagnosing a battery according to claim 7,
wherein the diagnostic model is configured to further display importance for the key area in the diagnostic result image.

9. The apparatus for diagnosing a battery according to claim 8,
wherein the diagnostic model is configured to display an area in which the importance is greater than or equal to a preset threshold value as the key area in the entire area of the diagnostic image.

10. The apparatus for diagnosing a battery according to claim 1,
wherein the control unit is configured to diagnose a cause of the state of the battery as one of a preset plurality of reference causes and set a usage condition of the battery to correspond to the diagnostic result.

11. The apparatus for diagnosing a battery according to claim 1,
wherein the image converting unit is configured to generate the diagnostic image by synthesizing the one or more images.

12. A battery pack, comprising the apparatus for diagnosing a battery according to any one of claims 1 to 11.

13. A server, comprising the apparatus for diagnosing a battery according to any one of claims 1 to 11.

14. A method for diagnosing a battery, comprising:
a profile obtaining step of obtaining one or more profiles based on voltage and capacity of a battery;
an image converting step of converting each of the one or more profiles into an image and generate a diagnostic image from the converted one or more images; and
a diagnosing step of diagnosing a state of the battery corresponding to the diagnostic image using a pre-learned diagnostic model.
